# EUROPÄISCHE PATENTSCHRIFT

(11) **EP 2 656 415 B1**
(45) Veröffentlichungstag und Bekanntmachung des Hinweises auf die Patenterteilung: **10.09.2014**
(21) Anmeldenummer: 11788134.2
(22) Anmeldetag: 23.11.2011
(51) Int. Cl.: H01M 2/34, H01M 2/10, H01M 2/30, G01D 11/24, H05K 7/02

(54) **TRANSPORTSICHERUNG FÜR EINE BATTERIEEINHEIT**
TRANSPORT-SECURING MEANS FOR A BATTERY UNIT
SÉCURITÉ DE TRANSPORT POUR UNE UNITÉ DE BATTERIE

(30) Priorität: 21.12.2010 DE 102010063777
(43) Veröffentlichungstag der Anmeldung: 30.10.2013
(73) Patentinhaber: Endress+Hauser Process Solutions AG, 4153 Reinach (CH)
(72) Erfinder: SEILER, Christian, 79424 Auggen (DE); FIEDLER, Marc, CH-4153 Reinach (CH); PROBST, Stefan, 79576 Weil am Rhein (DE); MANNBAR, Uwe, F-68128 Villag-Neuf (FR); THOREN, Werner, 79585 Steinen (DE)
(74) Vertreter: Andres, Angelika Maria
(86) Internationale Anmeldenummer: PCT/EP2011/070847
(87) Internationale Veröffentlichungsnummer: WO 2012/084393

(56) Entgegenhaltungen:
- WO-A1-2006/027284
- WO-A2-2011/139653
- US-A- 4 751 452
- US-A1- 2009 111 008
- US-B1- 6 357 534

## Beschreibung

Die Erfindung bezieht sich auf eine Vorrichtung mit einer Elektronikeinheit und einer zur Energieversorgung der Elektronikeinheit vorgesehenen Batterieeinheit, wobei die Batterieeinheit ein erstes Formteil aufweist, und wobei die Elektronikeinheit ein zweites Formteil aufweiset, wobei das erste und das zweite Formteil miteinander verbindbar sind.

In der Prozessautomatisierungstechnik ebenso wie in der Fertigungsautomatisierungstechnik werden vielfach Feldgeräte eingesetzt, die zur Erfassung und/oder Beeinflussung von Prozessgrößen dienen. Zur Erfassung von Prozessgrößen dienen Messgeräte bzw. Sensoren, wie beispielsweise Füllstandsmessgeräte, Durchflussmessgeräte, Druck- und Temperatur-messgeräte, pH-Redoxpotentialmessgeräte, Leitfähigkeitsmessgeräte, etc., welche die entsprechenden Prozessvariablen Füllstand, Durchfluss, Druck, Temperatur, pH-Wert bzw. Leitfähigkeit erfassen. Zur Beeinflussung von Prozessgrößen dienen Aktoren, wie zum Beispiel Ventile oder Pumpen, über die der Durchfluss einer Flüssigkeit in einem Rohrleitungsabschnitt bzw. der Füllstand in einem Behälter geändert werden kann.

Als Feldgeräte werden im Prinzip alle Geräte bezeichnet, die prozessnah eingesetzt werden und die prozessrelevante Informationen liefern oder verarbeiten. Neben den zuvor genannten Messgeräten/Sensoren und Aktoren werden als Feldgeräte allgemein auch solche Einheiten bezeichnet, die direkt an einem Feldbus angeschlossen sind und zur Kommunikation mit den übergeordneten Einheiten dienen, wie z.B. Remote I/Os, Gateways, Linking Devices und Funkeinheiten. Eine Vielzahl solcher Feldgeräte wird von der Firma Endress+Hauser hergestellt und vertrieben.
In modernen Industrieanlagen sind Feldgeräte in der Regel über Bussysteme (Profibus®, Foundation Fieldbus®, HART®, etc.) mit übergeordneten Einheiten verbunden. Normalerweise handelt es sich bei den übergeordneten Einheiten um Leitsysteme bzw. Steuereinheiten, wie beispielsweise eine SPS (speicherprogrammierbare Steuerung) oder eine PLC (Programmable Logic Controller). Die übergeordneten Einheiten dienen unter anderem zur Prozesssteuerung, Prozessvisualisierung, Prozessüberwachung sowie zur Inbetriebnahme der Feldgeräte. Die von den Feldgeräten, insbesondere von Sensoren, erfassten Messwerte werden über das angeschlossene Bussystem an eine oder gegebenenfalls auch an mehrere übergeordnete Einheit(en) übermittelt. Daneben ist auch eine Datenübertragung von der übergeordneten Einheit über das Bussystem an die Feldgeräte erforderlich; diese dient insbesondere zur Konfigurierung und Parametrierung von Feldgeräten oder zu Diagnosezwecken. Allgemein gesprochen, wird das Feldgerät über das Bussystem von der übergeordneten Einheit her bedient.

Neben einer drahtgebundenen Datenübertragung zwischen den Feldgeräten und der übergeordneten Einheit besteht auch die Möglichkeit einer drahtlosen (wireless) Datenübertragung. Insbesondere in den Bussystemen Profibus®, Foundation Fieldbus® und HART® ist eine drahtlose Datenübertragung über Funk spezifiziert. Ferner sind Funknetzwerke für Sensoren in dem Standard IEEE 802.15.4 näher spezifiziert.

Zur Realisierung einer drahtlosen Datenübertragung sind neuere Feldgeräte, insbesondere Sensoren und Aktoren, teilweise als Funk-Feldgeräte ausgebildet. Diese weisen in der Regel eine Funkeinheit und eine Stromquelle als integrale Bestandteile auf. Dabei können die Funkeinheit und die Stromquelle in dem Feldgerät selbst oder in einer dauerhaft an dem Feldgerät angeschlossenen Funkeinheit vorgesehen sein. Durch die Stromquelle wird eine autarke Energieversorgung des Feldgerätes ermöglicht.

Daneben besteht die Möglichkeit, Feldgeräte ohne interne Funkeinheiten - also die installierte Basis - durch die Kopplung mit mindestens einer Funkeinheit zu einem Funk-Feldgerät aufzurüsten. Eine entsprechende Funkeinheit ist beispielsweise in der Druckschrift WO 2005/103851 A1 beschrieben. Die Funkeinheit wird in der Regel an eine Feldbus-Kommunikationsschnittstelle des Feldgerätes lösbar angeschlossen. Über die Feldbus-Kommunikationsschnittstelle kann das Feldgerät die über das Bussystem zu übermittelnden Daten an die Funkeinheit senden, die diese dann über Funk an den Zielort übermittelt. Umgekehrt kann die Funkeinheit über Funk Daten empfangen und über die Feldbus-Kommunikationsschnittstelle an das Feldgerät weiterleiten. Die Versorgung des Feldgeräts mit elektrischer Leistung erfolgt dann in der Regel über eine Energieversorgungseinheit der Funkeinheit.

Bei autarken Funk-Feldgeräten mit oder ohne Funkeinheit wird die Kommunikation, beispielsweise mit einer übergeordneten Einheit, in der Regel über die drahtlose Schnittstelle des Funk-Feldgerätes bzw. der Funkeinheit abgewickelt. Zusätzlich weisen solche Funk-Feldgeräte bzw. Funkeinheiten in der Regel eine drahtgebundene Kommunikationsschnittstelle auf. Beispielsweise ist in dem HART®-Standard vorgesehen, dass Funk-Feldgeräte neben einer drahtlosen Schnittstelle auch eine drahtgebundene Kommunikationsschnittstelle aufweisen müssen. Über solch eine drahtgebundene Kommunikationsschnittstelle ist beispielsweise vor Ort eine Konfiguration des Funk-Feldgerätes bzw. der Funkeinheit über eine Service- und/oder Bedieneinheit, wie beispielsweise einen Handheld Communicator, die/der an der drahtgebundenen Kommunikationsschnittstelle angeschlossen wird, möglich. Ferner kann die drahtgebundene Kommunikationsschnittstelle als Feldbus-Kommunikationsschnittstelle ausgebildet sein, so dass die Kommunikation darüber entsprechend einem Bussystem, wie beispielsweise entsprechend einem der standardisierten Bussysteme Profibus®, Foundation Fieldbus® oder HART®, abgewickelt wird. Über solch eine Feldbus-Kommunikationsschnittstelle kann das Funk-Feldgerät bzw. die Funkeinheit auch an einen entsprechenden drahtgebundenen Feldbus angeschlossen werden.

Diese Feldgeräte bzw. Funkeinheiten weisen zur Ausführung ihrer Funktionen und Funktionalitäten Elektroniken, d.h. Elektronikeinheiten, auf. Diese Elektronikeinheiten beinhalten bspw. Programme oder Algorithmen durch die entsprechende Funktionen ausgeführt werden. Zu diesem Zweck benötigt die Elektronikeinheit eine gewisse Menge an elektrischer Energie. Die Energieversorgungseinheit bzw. die Stromquelle einer Funkeinheit, eines Feldgerätes oder eines Funk-Feldgerätes erfolgt üblicherweise über eine Batterie. Aus den Offenlegungsschriften DE 102008036554 A1, DE 102008037193 A1, DE 200810038415 A1 sind derartige Batterieeinheiten, die bevorzugt in der Prozessautomatisierung eingesetzt werden, bekannt geworden. Unter Batterie werden hierbei allgemein neben einer galvanischen Zelle auch andere Energiespeicher wie bspw. ein Akkumulator verstanden.

Ferner ist es auch üblich, die Batterie über Kabel mit der entsprechenden Elektronikeinheit, die im Fall eines Feldgerätes auch als Betriebselektronik bezeichnet wird, zu verbinden. Eine Kontaktierung der Batterie erfolgt dann vorzugsweise erst bei der Inbetriebnahme eines entsprechenden Feldgerätes, d.h. das Kabel ist während der Lagerung und des Transports nicht mit der Elektronikeinheit bzw. der Batterie verbunden. Kabel mit einer Kupplung und/oder entsprechendem Stecker sind aber gerade bei einer häufigen Benutzung nicht robust genug und können leicht beschädigt werden.

Vorgenannte Batterieeinheiten sind im Fall von Feldgeräten außerdem nur mit einer, insbesondere symmetrischen, bevorzugt zentral angeordneten, Kontaktierung bekannt geworden. Derartige Batterieeinheiten verfügen aber aufgrund ihrer Bauweise nur über eine mögliche Einbauposition, in der sie mit der Elektronikeinheit verbunden werden und/oder in ein Gehäuse eingesetzt werden können.

Aufgrund von sicherheitstechnischen Bedenken und Auflagen muss die Batterieeinheit getrennt vom zugehörigen Gerät transportiert werden. Zumal für bestimmte Transportwege, z.B. bei einem Transport vermittels eines Flugzeugs, das jeweilige Gerät während des Transports nicht angeschaltet sein darf.

Ferner ist es bei den aus dem Stand der Technik bekannten Lösungen von Nachteil, dass sich nach der Kontaktierung immer ein gewisser Entladestrom einstellt, was zu einer verminderten Laufzeit der Batterie und also des jeweiligen Gerätes führt.

Aus dem Stand der Technik ist insbesondere aus der WO 2006/027284 A1 eine Vorrichtung zum Verriegeln von Elektrogeräten mit Batteriepacks zur Stromversorgung bekannt geworden. Dort wird eine zweistufige Verriegelung des Batteriepacks vorgeschlagen, wobei in einer ersten Einbauposition noch kein Kontakt zwischen den Anschlüssen des Batteriepacks und des dort vorgesehenen Elektrowerkzeugs erfolgt und wobei der elektrische Kontakt erst in einer zweiten Einbauposition hergestellt wird, die durch Einschieben des Batteriepacks in das Elektrowerkzeug hergestellt wird. Da die Kontaktierung durch das Einschieben des Batteriepacks erfolgt, ist aber gemäß WO 2006/027284 A1 ausreichend Platz für wenigstens zwei Einbaupositionen vorzusehen. Dies ist aber gerade bei Geräten, bei denen die Batterieeinheit vollständig in einem Gehäuse untergebracht ist, oftmals nicht möglich. Ferner muss bei der WO 2006/027284 die Batterie von außen zugänglich sein oder das Gehäuse geöffnet werden.

Auch aus US 4 751 452 A, US 2009/111 008 A1, US 6 357 534 B1, WO 2006/027 284 A2 und WO 2011/139 653 sind Vorrichtungen bekannt.

Es ist daher Aufgabe der vorliegenden Erfindung eine platzsparende Vorrichtung vorzuschlagen, die eine variable Versorgung einer Elektronikeinheit mit elektrischer Energie aus einer Batterieeinheit erfolgtermöglicht.

Die Aufgabe wird erfindungsgemäß durch eine Vorrichtung nach Anspruch 1 gelöst,

Die Batterieeinheit kann also durch Drehen des ersten Formteils um eine Symmetrieachse in eine erste Stellung gebracht werden, so dass das erste Formteil it dem zweiten Formteil in einer ersten Einbauposition verbindbar ist. Durch das Drehen des ersten Formteils bezüglich des zweiten Formteils kann das erste Formteil ebenso in eine zweite Stellung gebracht werden, so dass das erste Formteil in einer zweiten, sich von der ersten Einbauposition unterscheidenden, Einbauposition mit dem zweiten Formteil verbindbar ist. In den verschiedenen Einbaupositionen kann die Batterieeinheit mit der Elektronikeinheit über das erste und das zweite Formteil zumindest mechanisch verbunden sein. Dazu kann eine kraftschlüssige Verbindung zwischen den Formteilen bspw. mittels zumindest eines Bolzen, einer Niete und/oder eines Gewindes und einer Gewindeschraube oder einer Steckverbindung, dienen. Das erste und das zweite Formteil können zudem zumindest in den verschiedenen Einbaupositionen eine einander entsprechende insbesondere im Wesentlichen passgenaue Form aufweisen.

Natürlich kann anstelle des ersten Formteils auch das zweite Formteil um eine Symmetrieachse gedreht werden, da bei der Einbauposition nur die relative Stellung der beiden Teile zueinander ausschlaggebend ist. Da die Batterieeinheit und das erste Formteil aber oftmals kleiner und leichter ausgelegt und somit einfacher zu handhaben ist als die Elektronikeinheit, die zudem oftmals zum Zeitpunkt des Verbindens mit der Batterieeinheit in einem Gehäuse angeordnet ist, wird auf die Batterieeinheit bzw. deren erstes Formteil Bezug genommen, um das das Drehen, bspw. in die erste oder zweite Stellung, über die eine Verbindung in der ersten bzw. zweiten Einbauposition ermöglicht wird, zu beschreiben.

Das Drehen der Batterieeinheit bzw. des ersten Formteils erfolgt durch Drehen der Batterieeinheit bzw. des ersten Formteils bspw. um eine Symmetrieachse oder auch ggfs. mehrere Symmetrieachsen der Batterieeinheit. Die Batterieeinheit kann bspw. mehrere Seiten aufweisen, wobei unterschiedliche Seiten zum Verbinden der Batterieeinheit mit der Elektronikeinheit vorgesehen sein können, und wobei die Energieversorgung der Elektronikeinheit in Abhängigkeit der Einbauposition in der die Batterieeinheit mit der Elektronikeinheit verbunden ist, erfolgt. Natürlich kann auch durch ein Drehen der Batterieeinheit um eine einzige Symmetrieachse die erste Stellung in die zweite Stellung überführen, so dass ein Verbinden der Batterieeinheit in der ersten oder der zweiten Einbauposition erfolgen kann. Bevorzugt erfolgt dabei die Verbindung zwischen dem ersten Formteil und dem zweiten Formteil über dieselbe Seite der Batterieeinheit, so dass durch Drehen um eine durch diese Seite verlaufende Symmetrieachse die erste Stellung in die zweite Stellung überführbar ist und die Batterieeinheit somit in der ersten oder zweiten Einbauposition mit der Elektronikeinheit verbindbar ist.

In einer ersten Einbauposition kann dann bspw. eine Energieversorgung der Elektronikeinheit mit einem ersten vorgegebenen Wert, bspw. einem ersten vorgegebenen Strom- und/oder Spannungswert, erfolgen, während in einer zweiten Einbauposition die Energieversorgung mit einem zweiten vorgegebenen Wert, bspw. einem zweiten vorgegebenen Strom- und/oder Spannungswert erfolgen kann. Dabei können sich der erste und der zweite vorgegebene Strom- und/oder Spannungswert voneinander unterscheiden. Die entsprechenden Mittel zur Spannungsbegrenzung können dabei Teil der Batterieeinheit und/oder Teil der Elektronikeinheit sein. Es kann sich dabei bspw. um eine entsprechende Diodenanordnung oder andere Strom- und/oder Spannungsbegrenzende Mittel handeln, die im Falle der ersten bzw. der zweiten Einbauposition auf der Batterieeinheit und/oder der Elektronikeinheit kontaktiert werden. Insbesondere kann eine Einbauposition vorgesehen sein, in der die Elektronikeinheit nicht mit Energie aus der Batterieeinheit versorgt wird, bspw. indem durch die Verbindung zwischen der Batterieeinheit zwar ein mechanischer Kontakt jedoch kein elektrischer, insbesondere galvanischer, Kontakt gebildet wird.

Ferner kann das erste Formteil und das zweite Formteil so ausgestaltet sein, dass sich durch Drehen um eine Achse die erste Stellung in die zweite Stellung überführen lässt, so dass die Batterieeinheit in der ersten oder der zweiten Einbauposition mit der Elektronikeinheit verbunden werden kann.

Erfindungsgemäß ist die Batterieeinheit in einer ersten Einbauposition elektrisch mit der Elektronikeinheit verbunden und dient zur Energieversorgung der Elektronikeinheit. Die erste Einbauposition kann also durch das erste und das zweite Formteil nicht nur zur elektrischen Verbindung sondern auch zur mechanischen Verbindung der Batterieeinheit mit der Elektronikeinheit dienen.

Erfindungsgemäß ist das erste Formteil der Batterieeinheit in einer zweiten Einbauposition mit dem zweiten Formteil der Elektronikeinheit verbunden, ohne dass die Batterieeinheit elektrisch mit der Elektronikeinheit verbunden ist. Die zweite Einbauposition dient also nur zur mechanischen Verbindung der Batterieeinheit mit der Elektronikeinheit.

In einer weiteren Ausführungsform der Vorrichtung bildet das erste Formteil bzw. das zweite Formteil ein Gehäuse, das eine Batterie der Batterieeinheit bzw. die Elektronikeinheit zumindest teilweise enthält. Die Elektronikeinheit sowie die Batterieeinheit können mitsamt ihren Gehäusen in ein weiteres Gehäuse, bspw. dem eines Feldgerätes, untergebracht sein. Dieses Gehäuse kann bspw. einen abnehmbaren Deckel aufweisen, wobei durch die durch den Deckel verschließbare Öffnung hindurch die Batterieeinheit in das Gehäuse einsetzbar und mit der Elektronikeinheit verbindbar ist. Das Gehäuse der Elektronikeinheit und/oder der Batterieeinheit besteht dabei bspw. aus einem Kunststoffmaterial, in das bspw. die Batterie bzw. die Bausteine der Elektronikeinheit wenigstens teilweise mit einem Vergussmaterial eingegossen sind.

In einer weiteren Ausführungsform der Vorrichtung erfolgt die Energieversorgung über wenigstens ein Kontaktelement bzw. Gegenkontaktelement, bei welchem Kontaktelement bzw. Gegenkontaktelement es sich insbesondere um eine Buchse bzw. einen Stecker handelt, die an dem ersten bzw. zweiten Formteil angebracht sind. Das Kontaktelement kann dabei mit der Batterieeinheit und das Gegenkontaktelement an der Elektronikeinheit verbunden sein. Bei dem Kontakt- bzw. Gegenkontaktelement kann es sich um zueinander korrespondierende Kontaktelemente handeln, die bspw. ineinander in Eingriff gelangen, um die mechanische und/oder elektrische Verbindung zwischen der Batterieeinheit und der Elektronikeinheit herzustellen.

In einer weiteren nicht erfindungsgemäßen Ausführungsform der Vorrichtung weist das zweite Formteil wenigstens ein Blindgegenkontaktelement, bspw. eine Blindbuchse bzw. einen Blindstecker, auf, in den das Kontaktelement der Batterieeinheit einbringbar ist, wobei das Blindgegenkontaktelement keinen elektrischen Kontakt herstellt.
Das zweite Formteil kann also in dieser Ausführungsform wenigstens ein Gegenkontaktelement und ein Blindgegenkontaktelement aufweisen. Das Kontaktelement der Batterieeinheit kann dann entsprechend der ersten Einbauposition mit dem Gegenkontaktelement verbunden werden, so dass ein elektrischer Kontakt zwischen der Batterieeinheit und der Elektronikeinheit besteht oder das Kontaktelement der Batterieeinheit kann entsprechend der zweiten Einbauposition mit dem Blindgegenkontaktelement verbunden werden, so dass die Batterieeinheit nur mechanisch mit der Elektronikeinheit verbindbar ist. Alternativ kann die Batterieeinheit über ein Kontaktelement und eine Blindkontaktelement verfügen, wobei die Elektronikeinheit dann über wenigstens ein Gegenkontaktelement verfügt, so dass in der ersten Einbauposition das Gegenkontaktelement mit dem Kontaktelement verbunden ist und wobei in der zweiten Einbauposition das Gegenkontaktelement mit dem Blindkontaktelement verbunden ist. Die Verbindung zwischen dem ersten und dem zweiten Formteil kann dabei unter Verwendung bekannter Befestigungsmittel wie eines Rastelementes oder eines Schraubelementes hergestellt werden.

In einer weiteren nicht erfindungsgemäßen Ausführungsform der Vorrichtung sind das Blindgegenkontaktelement und das Gegenkontaktelement symmetrisch bzgl. einer gemeinsamen Achse, insbesondere einer Symmetrieachse, des ersten und des zweiten Formteils angeordnet, wobei das wenigstens eine Kontaktelement der Batterieeinheit asymmetrisch, insbesondere dezentral, bzgl. der Achse, insbesondere der Symmetrieachse, angeordnet ist. Durch diese symmetrische Anordnung, bei der das Blindgegenkontaktelement und das Gegenkontaktelement z.B. auf einem Umfang einer Kreislinie liegen oder spiegelsymmetrisch bzgl. einer Ebene durch die Achse, insbesondere die Symmetrieachse, angeordnet sind, kann das Kontaktelement des ersten Formteils durch einfaches Ausrichten, insbesondere Drehen, in die erste bzw. zweiten Stellung gebracht werden, so dass die Verbindung zwischen Batterieeinheit und Elektronikeinheit in der ersten oder der zweiten Einbausposition erfolgen kann.

In einer weiteren nicht erfindungsgemäßen Ausführungsform der Vorrichtung weist das erste Formteil wenigstens ein Blindkontaktelement, bspw. eine Blindbuchse bzw. einen Blindstecker, auf, in den das Gegenkontaktelement der Elektronikeinheit einbringbar ist, wobei das Blindkontaktelement keinen elektrischen Kontakt herstellt. Das Blindkontaktelement dient eben nur zur mechanischen Verbindung bzw. zur Aufnahme des Gegenkontakts der Elektronikeinheit, damit eine mechanische Verbindung zwischen der Batterieeinheit und der Elektronikeinheit herstellbar ist, in dem das erste und das zweite Formteil sich im Wesentlichen passgenau aneinander fügen lassen.

In einer weiteren nicht erfindungsgemäßen Ausführungsform der Vorrichtung sind das Blindkontaktelement und das Kontaktelement symmetrisch bzgl. einer gemeinsamen Achse, insbesondere einer Symmetrieachse, des ersten und des zweiten Formteils angeordnet, und das wenigstens eine Gegenkontaktelement der Batterieeinheit ist asymmetrisch bzgl. der Achse, bei der es sich bevorzugt um die Symmetrieachse, angeordnet.

Erfindungsgemäß ist die erste Stellung durch Drehen der Batterieeinheit bezüglich der Elektronikeinheit, um eine Symmetrieachse, ineinander überführbar, so dass ein Einbau der Batterieeinheit entweder in der ersten oder in der zweiten Einbauposition erfolgen kann.

In einer weiteren nicht erfindungsgemäßen Ausführungsform der Vorrichtung sind das Kontaktelement, das Gegenkontaktelement und das Blindkontaktelement bzw. das Blindgegenkontaktelement durch Ausrichten, insbesondere durch Drehen, vorzugsweise um 180°, der Batterieeinheit bzw. der Elektronikeinheit in den verschiedenen Stellungen anordenbar, so dass die in den verschiedenen Einbaupositionen verbindbar, insbesondere ineinander einsteckbar, sind. Das Ausrichten der Batterieeinheit erfolgt dabei durch Drehen um eine Achse der Batterieeinheit.

In einer weiteren nicht erfindungsgemäßen Ausführungsform der Vorrichtung weisen das erste Formteil und das zweite Formteil jeweils eine Stirnseite auf, an der das Kontaktelement, das Gegenkontaktelement und Blindkontaktelement bzw. das Blindgegenkontaktelement angeordnet sind, wobei das erste und das zweite Formteil in jeder der vorgesehenen Einbaupositionen zumindest an der Stirnseite zwischen dem ersten und dem zweiten Formteil im Wesentlichen deckungsgleich anordenbar sind. Durch eine derartige Anordnung kann ein platzsparender Einbau der Batterieeinheit erreicht werden. Dabei kann die Ausrichtung der Batterieeinheit durch entsprechende Drehung um eine Achse, die durch diese Stirnseite, insbesondere mittig, hindurch geht, erfolgen.

Die Batterieeinheit ist in mehreren Einbaupositionen mit einer Elektronikeinheit verbindbar. Vorzugsweise verfügt die Batterieeinheit dafür im Bereich des ersten Formteils über wenigstens ein Kontaktelement das mit einem entsprechenden Gegenkontaktelement der Elektronikeinheit verbindbar ist, wobei über das erste und das zweite Formteil in Abhängigkeit der Einbauposition eine mechanische und/oder auch elektrische Verbindung zwischen der Batterieeinheit und der Elektronikeinheit hergestellt werden kann. Ferner kann die Batterieeinheit ein Blindkontaktelement aufweisen. Dabei kann das Kontakt- bzw. Blindkontaktelement der Batterieeinheit versetzt zu einer zentral durch die Batterieeinheit verlaufenden Achse angeordnet sein. Dadurch kann die Batterieeinheit insbesondere durch Drehung um diese mittige Achse in eine erste und eine zweite Stellung gebracht werden, so dass die Batterieeinheit insbesondere in der ersten bzw. der zweiten Einbauposition mit der Elektronikeinheit verbindbar ist.

Die Elektronikeinheit kann im Bereich des zweiten Formteils entsprechend über zumindest ein erstes Gegenkontaktelement verfügen, so dass die Batterieeinheit in mehreren Einbaupositionen mit dem Gegenkontaktelement verbindbar ist, wobei über das erste und das zweite Formteil in Abhängigkeit der Einbauposition eine mechanische und/oder auch elektrische Verbindung zwischen der Batterieeinheit und der Elektronikeinheit hergestellt werden kann. Ferner kann neben dem Gegenkontaktelement ein Blindgegenkontaktelement vorgesehen sein, wobei das Blindgegenkontaktelement symmetrisch zu einer durch die Elektronikeinheit verlaufende, insbesondere mittige, Achse, bevorzugt auf derselben Seite der Elektronikeinheit, angeordnet ist. Dadurch kann durch Ausrichten der Batterieeinheit, insbesondere durch Drehen der Batterieeinheit um eine Achse der Batterieeinheit entweder das Gegenkontaktelement oder das Blindgegenkontaktelement der Elektronikeinheit durch das Kontaktelement der Batterieeinheit kontaktiert werden.

Wie einleitend bereits erwähnt, ist derartige Batterieeinheit bspw. zum Betreiben von autarken Feldgeräten insbesondere Funkfeldgeräten, die bspw. mit einer Funkeinheit nachgerüstet werden, erforderlich. Zum Zweck des Transports oder zum Einstellen der Energieversorgung eines solchen Feldgerätes oder einer solchen Funkeinheit kann das Feldgerät bzw. die Funkeinheit über eine vorgeschlagene Elektronikeinheit und eine vorgeschlagene Batterieeinheit verfügen.

In einer Ausführungsform des Feldgerätes handelt es sich demnach bei dem Feldgerät um ein autarkes Feldgerät, bei dem die Energieversorgung nur vermittels der Batterieeinheit erfolgt.

Die Erfindung wird anhand der nachfolgenden Zeichnungen näher erläutert. Es zeigt:

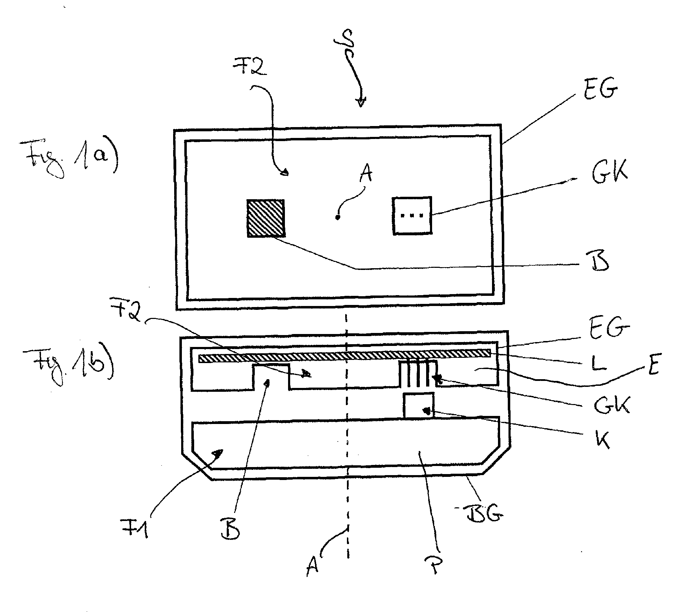

Fig. 1 a): eine schematische Darstellung einer Draufsicht auf die Stirnseite eines Formteils einer Elektronikeinheit
Fig. 1 b): eine schematische Darstellung eines Schnitts durch ein Elektronikgehäuse und ein Batteriegehäuse auf Höhe der Kontakt- bzw. Gegenkontaktelemente.

Figur 1 zeigt eine Draufsicht auf eine Stirnseite S der Elektronikeinheit E. Dabei ist das Gehäuse der Elektronikeinheit, auch als Elektronikgehäuse EG bezeichnet, erkennbar, wobei das Elektronikgehäuse EG im Bereich der Stirnseite S ein zweites Formteil bildet mit dem ein erstes Formteil einer Batterieeinheit P verbindbar ist. Ferner sind in Fig. 1a) ein Gegenkontaktelement GK und ein Blindgegenkontaktelement B dargestellt, wobei über das Gegenkontaktelement GK eine elektrische Verbindung zwischen der Batterieeinheit P und der Elektronikeinheit E erfolgt, während das Blindgegenkontaktelement B lediglich zur Aufnahme des Kontaktelements K der Batterieeinheit dient, um eine mechanische im Wesentlichen passgenaue Verbindung zwischen dem ersten Formteil der Batterieeinheit P und dem zweiten Formteil der Elektronikeinheit E zu ermöglichen. Durch Drehen der Elektronikeinheit E samt Elektronikgehäuse EG um eine Achse A kann die Stellung der Elektronikeinheit geändert werden, so dass eine Batterieeinheit P in der ersten oder der zweiten Einbauposition mit der Elektronikeinheit E verbunden werden kann.

Fig. 1b) zeigt eine schematische Darstellung eines Schnitts durch eine Elektronikeinheit E mit einem Elektronikgehäuse EG und eine Batterieeinheit P mit einem Batteriegehäuse BG auf Höhe der Kontakt-, Gegenkontakt bzw. Blindkontaktelemente K, GK, B. Dabei sind die Batterieeinheit P und die Elektronikeinheit E in ein weiteres Gehäuse, bspw. eines Feldgerätes, eingebracht. Zur besseren Veranschaulichung ist die Batterieeinheit P dabei nicht in der ersten Einbauposition gezeigt sondern in einer ersten Stellung, so dass die Batterieeinheit P mit der Elektronikeinheit E in der ersten Einbauposition verbindbar ist. Die Batterieeinheit P weist in dem Ausführungsbeispiel gemäß Fig. 1b) ein Kontaktelement K auf, dass mit dem Gegenkontaktelement GK der Elektronikeinheit E in Eingriff gelangen kann, so dass eine Versorgung der Elektronikeinheit E mit elektrischer Energie aus einer Batterie der Batterieeinheit P erfolgen kann.

Das Kontaktelement K besteht dabei aus einer Buchse, welche Teil des ersten Formteils F1 ist und mit einem Stecker, der Teil des zweiten Formteils F2 ist, in Eingriff gelangen kann. Stecker und Buchse können dabei von einem Stecker- oder Buchsengehäuse umgeben sein, das sowohl zum Berührungsschutz, zur mechanischen Festigkeit der Verbindung als auch der Abschirmung dienen kann.

Die Steckkontakte des Steckers sind dabei mit einer Leiterplatte L verbunden auf der Elektronikbauteile der Elektronikeinheit E angeordnet sind.

Ferner kann ein Blindgegenkontaktelement B vorgesehen sein, in das das Kontaktelement K der Batterieeinheit P eingebracht werden kann. Dies stellt die zweite Einbauposition dar, in der die Batterieeinheit P und Elektronikeinheit miteinander verbindbar sind. In dieser zweiten Einbauposition ist die Batterieeinheit P nicht mit der Leiterplatte L der Elektronikeinheit E verbunden, so dass keine elektrische Verbindung zwischen der Batterieeinheit P und der Elektronikeinheit E besteht. Die zweite Einbauposition kann somit zur Transportsicherung der Batterieeinheit P verwendet werden.

Das erste und das zweite Formteil F1, F2 und das Gehäuse der Batterieeinheit P und der Elektronikeinheit E können dabei aus einem Kunststoff oder einem anderen geeigneten elektrisch isolierenden Material bestehen.

### Bezugszeichenliste

- EG: Elektronikgehäuse
- B: Blindgegenkontaktelement
- K: Kontaktelement
- GK: Gegenkontaktelement
- L: Leiterplatter
- A: Achse
- P: Batterieeinheit
- S: Stirnseite des zweiten Formteils
- BG: Batteriegehäuse
- F1: erstes Formteil
- F2: zweites Formteil
- E: Elektronikeinheit

## Patentansprüche

1. Vorrichtung mit einer Elektronikeinheit (E) und einer zur Energieversorgung der Elektronikeinheit (E) vorgesehenen Batterieeinheit (P), wobei die Batterieeinheit (P) ein erstes Formteil (F1) aufweist, und wobei die Elektronikeinheit ein zweites Formteil (F2) aufweist, wobei das erste und das zweite Formteil (F1, F2) miteinander verbindbar sind, wobei die Energieversorgung der Elektronikeinheit (E) durch die Batterieeinheit (P) in Abhängigkeit der Einbauposition, in welcher das erste Formteil (F1) mit dem zweiten Formteil (F2) verbunden ist, erfolgt, wobei die Batterieeinheit (P) in einer ersten Einbauposition elektrisch mit der Elektronikeinheit (E) verbunden ist und zur Energieversorgung der Elektronikeinheit (E) dient, dass das erste Formteil (F1) der Batterieeinheit (P) in einer zweiten Einbauposition mit dem zweiten Formteil (F2) der Elektronikeinheit (E) verbunden ist, ohne dass die Batterieeinheit (P) elektrisch mit der Elektronikeinheit (E) verbunden ist,
**dadurch gekennzeichnet,**
**dass** durch Drehen um eine Symmetrieachse des ersten Formteils (F1) bzw. des zweiten Formteils (F2), das erste Formteil (F1) und das zweite Formteil (F2) in unterschiedlichen Einbaupositionen miteinander verbindbar sind.

2. Vorrichtung nach Anspruch 1,
**dadurch gekennzeichnet,**
**dass** das erste Formteil (F1) bzw. das zweite Formteil (F2) ein Gehäuse (BG, EG) bildet, das eine Batterie der Batterieeinheit (P) bzw. die Elektronikeinheit (E) enthält.

3. Vorrichtung nach einem der vorherigen Ansprüche,
**dadurch gekennzeichnet,**
**dass** die Energieversorgung über wenigstens ein Kontaktelement (K) bzw. Gegenkontaktelement (GK), bei welchen Kontaktelement (K) bzw. Gegenkontaktelement (GK) es sich insbesondere um eine Buchse bzw. einen Stecker handelt, die an dem ersten bzw. zweiten Formteil (F1, F2) angebracht sind, erfolgt.

4. Vorrichtung nach einem der vorherigen Ansprüche,
**dadurch gekennzeichnet,**
**dass** eine erste Stellung der Batterieeinheit (P) bezüglich der Elektronikeinheit (E), insbesondere durch Drehen um die Achse (A), bei der es sich bevorzugt um eine Symmetrieachse handelt, in eine zweite Stellung überführbar ist, so dass die Batterieeinheit (P) in der ersten oder der zweiten Einbauposition mit der Elektronikeinheit (E) verbindbar ist.

## Claims

1. Device with an electronic unit (E) and a battery unit (P) designed to supply energy to the electronic unit (E), wherein the battery unit (P) has a first molded piece (F1) and wherein the electronic unit (E) has a second molded piece (F2), wherein the first and the second molded piece (F1, F2) can be connected to one another, wherein energy is supplied to the electronic unit (E) by the battery unit (P) depending on the installation position in which the first molded piece (F1) is connected to the second molded piece (F2), wherein the battery unit (P) is electrically connected to the electronic unit (E) in a first installation position and is used to supply energy to the electronic unit (E), the first molded part (F1) of the battery unit (P) being connected to the second molded part (F2) of the electronic unit (E) in a second installation position without the battery unit (P) being electrically connected to the electronic unit (E),
**characterized in that**
the first molded part (F1) and the second molded part (F2) can be connected with one another in different installation positions by rotating around an axis of symmetry of the first molded part (F1) or the second molded part (F2) respectively.

2. Device as claimed in Claim 1,
**characterized in that**
the first molded part (F1) or the second molded part (F2) form a housing (BG, EG) which contains a battery of the battery unit (P) or the electronic unit (E).

3. Device as claimed in one of the previous claims,
**characterized in that**
energy is supplied via at least one contact element (K) or one counter-contact element (GK), said contact element (K) or counter-contact element (GK) particularly being a socket or a plug respectively being fitted at the first or the second molded part (F1, F2) respectively.

4. Device as claimed in one of the previous claims,
**characterized in that**
a first position of the battery unit (P) in relation to the electronic unit (E) can be changed to a second position, particularly by rotating around the axis (A), said axis preferably being an axis of symmetry, in such a way that the battery unit (P) can be connected to the electronic unit (E) in the first or the second installation position.

## Revendications

1. Dispositif avec une unité électronique (E) et une unité de batterie (P) destinée à l'alimentation en énergie de l'unité électronique (E), l'unité de batterie (P) présentant une première pièce moulée (F1) et l'unité électronique (E) présentant une deuxième pièce moulée (F2), la première et la deuxième pièce moulée (F1, F2) pouvant être reliées entre elles, l'alimentation en énergie de l'unité électronique (E) étant réalisée à travers l'unité de batterie (P) en fonction de la position de montage, dans laquelle la première pièce moulée (F1) est reliée avec la deuxième pièce moulée (F2), l'unité de batterie (E) étant reliée électriquement dans une première position avec l'unité électronique (E) et servant à l'alimentation en énergie de l'unité électronique (E), la première pièce moulée (F1) de l'unité de batterie (P) étant reliée dans une deuxième position de montage avec la deuxième pièce moulée (F2) de l'unité électronique (E), sans que l'unité de batterie (P) ne soit reliée électriquement avec l'unité électronique (E),
**caractérisé en ce**
**que**

2. Dispositif selon la revendication 1,
**caractérisé en ce**
**que** la première pièce moulée (F1) ou la deuxième pièce moulée (F2) forme un boîtier (BG, EG), qui contient une batterie de l'unité de batterie (P) ou l'unité électronique.

3. Dispositif selon l'une des revendications précédentes,
**caractérisé en ce**
**que** l'alimentation en énergie est réalisée à travers au moins un élément de contact (K) ou un élément de contre-contact (GK), élément de contact (K) ou contre-élément de contact (GK) pour lequel il s'agit notamment d'un connecteur femelle ou d'un connecteur mâle, qui est disposé sur la première ou la deuxième pièce moulée (F1, F2).

4. Dispositif selon l'une des revendications précédentes,
**caractérisé en ce**
**qu'**une première position de l'unité de batterie (P) par rapport à l'unité électronique (E) peut être transformée en une deuxième position notamment par rotation autour de l'axe (A), pour lequel il s'agit de préférence d'un axe de symétrie, de telle sorte que l'unité de batterie (P) puisse être reliée avec l'unité électronique (E) dans la première ou la deuxième position de montage.
